(19) Europäisches Patentamt
European Patent Office
Office européen des brevets

(11) Veröffentlichungsnummer: **0 194 265**
**B1**

(12) # EUROPÄISCHE PATENTSCHRIFT

(45) Veröffentlichungstag der Patentschrift: **21.02.90**

(51) Int. Cl.⁵: **H 01 L 29/24**, H 01 L 21/363, H 01 L 21/365, H 01 L 31/18, C 30 B 23/02, C 30 B 29/12

(21) Anmeldenummer: **85903198.1**

(22) Anmeldetag: **09.07.85**

(86) Internationale Anmeldenummer:
**PCT/CH 85/00110**

(87) Internationale Veröffentlichungsnummer:
**WO 86/00756** (**30.01.86** Gazette **86/3**)

(54) **INFRAROT-OPTO-ELEKTRONISCHER BAUTEIL.**

(30) Priorität: **10.07.84 CH 3460/84**

(43) Veröffentlichungstag der Anmeldung:
**17.09.86 Patentblatt 86/38**

(45) Bekanntmachung des Hinweises auf die Patenterteilung:
**21.02.90 Patentblatt 90/8**

(84) Benannte Vertragsstaaten:
**AT BE CH DE FR GB IT LI NL SE**

(56) Entgegenhaltungen:
**US-A- 4 117 504**

**Japanese Journal of Applied Physics, Band 22, Nr. 10, Oktober 1983, Tokio (JP); T. ASANO et al.: "Heteroepitaxial growth of group IIa fluoride films on Si substrates", Seiten 1474-1481.**
**Japanese Journal of Applied Physics, Band 21, Nr. 10, Oktober 1982, Tokio (JP); T. ASANO et al.: "Epitaxial growth of GE Films onto CaF2/Si structures", Seiten L630-L632.**
**Journal of Applied Physics, Band 45, Nr. 2, Februar 1974; D.K. HOHNKE et al.: "Epitaxial PbSe and Pb1-xSnxSe: growth and electrical properties", Seiten 892-897.**
**Applied Physics Letters, Band 44, Nr. 2, 15. Januar 1984, New York (US); P.W. SULLIVAN: "Growth of single crystal SrF2(001)/GaAs(001) structures by molecular**

(73) Patentinhaber: **Gesellschaft zur Förderung der industrieorientierten Forschung an den schweizerischen Hochschulen und weiteren Institutionen, Gloriastrasse 35, CH-8092 Zürich (CH)**

(72) Erfinder: **ZOGG, Hans, Weiherackerstrasse 1, CH-8114 Dänikon (CH)**

(74) Vertreter: **Scheidegger, Werner & Co., Stampfenbachstrasse 48 Postfach, CH-8023 Zürich (CH)**

(56) Entgegenhaltungen: (Fortsetzung)
**beam epitaxy", Seiten 190-192.**
**Japanese Journal of Applied Physics, Band 22, Supplement Nr. 22-1, 1982, Tokio (JP); H. ISHIWARA et al.: "Latticematched epitaxial growth of semiconductor films onto insulator (mixed fluoride)/Si structures", Seiten 201-204.**
**Journal of Crystal Growth, Band 60, Nr. 2, Dezember 1982, Amsterdam (NL); P.W. SULLIVAN et al.: "Insulating epitaxial films of BaF2, CaF2 and BaxCa1-xF2 grown by MBE on InP substrates", Seiten 403-413.**

**EP 0 194 265 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

ACTORUM AG

**Beschreibung**

Die vorliegende Erfindung betrifft einen opto-elektronischen Bauteil mit mindestens einem auf Infrarotstrahlung empfindlichen, Infrarotstrahlung führenden oder Infrarotstrahlung emittierenden optoelektronischen Wandler.

Es sind opto-elektronische Wärmebildkameras bekannt, bei denen in der Fokalebene einer Linsenanordnung für Infrarotstrahlen eine Vielzahl von auf Infrarotstrahlung empfindliche Sensoren angeordnet sind, von denen jeder in Abhängigkeit von der Intensität der auftreffenden Infrarotstrahlung ein elektrisches Signal liefert. Die Gesamtheit der so gewonnenen, verstärkten und nötigenfalls korrigierten elektrischen Signale erlaubt, das Wärmebild auszuwerten, z.B. für das menschliche Auge sichtbar zu machen. Bisher wurden für die Wärmebilddetektion zahlreiche Einzelsensoren in einem ein- oder zweidimensionalen Array oder Feld angeordnet. Die empfindlichsten dieser Arrays wurden bisher hybrid aufgebaut: Auf einem aus Schmalbandhalbleitermaterial bestehenden Chip sind die einzelnen Sensoren angeordnet. Auf einem zweiten Chip aus Silizium sind die nötigen elektronischen Schaltungsanordnungen zum Verstärken und Multiplexen der elektrischen Signale aufgebaut. Zwischen jedem Sensor und der Schaltungsanordnung auf dem Silizium-Chip ist eine eigene elektrische Verbindung erforderlich, was bei einer grösseren Anzahl von Sensoren recht unpraktisch ist und die Anzahl der in einem Array vereinigten Sensoren begrenzt. Derartige sogenannte intrinsische Focal Plane Arrays sind unter anderem in den regelmässig erscheinenden Konferenzberichten Proc. SPIE, Int. Soc. Opt. Engineering, Bd. 409 (1983), und frühere, beschrieben.

Aus der US-A-4 117 504 ist zudem eine Struktur bekannt, welche aus einer ersten Halbleiterschicht, einer zweiten Halbleiterschicht aus einem anderen Material und einer aus Teilschichten bestehenden Zwischenschicht besteht. Der Aufbau der Zwischenschicht lässt allerdings keine besonderen opto-elektronischen Eigenschaften des monolithischen Bauteils zu.

Ziel und Aufgabe der vorliegenden Erfindung ist es, einen opto-elektronischen Bauteil der eingangs genannten Art zu schaffen, der anstelle eines relativ komplizierten hybriden Aufbaus einen beträchtlich vereinfachten monolythischen Aufbau hat, so dass es z.B. ermöglicht ist, eine erhöhte Anzahl von Infrarot-Sensoren oder Infrarotstrahlung emittierenden Dioden in einem Bauteil zu integrieren.

Weiter soll die Zwischenschicht so ausgestaltet sein, dass eine epitaktische Verbindung der Halbleiterschichten in jedem Fall ermöglicht ist und zudem die Erzielung vorzüglicher opto-elektronischer Eigenschaften des monolithischen Bauteils gewährleistet ist.

Diese Aufgabe wird bei einem erfindungsgemässen opto-elektronischen Bauteil dadurch gelöst, dass auf einem Halbleitersubstrat mit Hilfe mindestens einer auf dem Substrat epitaktisch aufgewachsenen Zwischenschicht eine weitere Halbleiterschicht aus einem Schmalbandhalbleiter epitaktisch aufgewachsen ist und in dieser Schmalbandhalbleiterschicht der opto-elektronische Wandler integriert ist und die Zwischenschicht an ihren Grenzflächen zum Halbleitersubstrat und zu der Schmalbandhalbleiterschicht jeweils Gitterkonstanten aufweist, die zwischen oder in der Nähe jener des Halbleitersubstrates bzw. jener der Schmalbandhalbleiterschicht liegen, wobei die Zwischenschicht eine kubische Kalziumfluoridstruktur, insbesondere MF2, aufweist und aus mindestens zwei Teilzwischenschichten mit unterschiedlicher Zusammensetzung aufgebaut ist, deren Gitterkonstanten eine Reihe bilden von einem Wert in der Nähe der Gitterkonstante des Halbleitersubstrates zu einem Wert in der Nähe der Gitterkonstante der Schmalbandhalbleiterschicht.

Weitere erfindungsgemässe Merkmale des opto-elektronischen Bauteils ergeben sich aus den abhängigen Patentansprüchen.

Die Erfindung und ihre Vorteile sind im einzelnen nachstehend rein beispielsweise näher erläutert unter Bezugnahme auf die beigefügte Zeichnung.

Fig. 1 zeigt schematisch einen Querschnitt durch einen opto-elektronischen Bauteil gemäss der Erfindung und

Fig. 2 ist ein Diagramm zur Veranschaulichung der Gitterkonstanten verschiedener Materialien, die für den opto-elektronischen Bauteil geeignet sind.

Der in Fig. 1 dargestellte opto-elektronische Bauteil weist ein Halbleitersubstrat 1, eine darauf epitaktisch aufgewachsene Zwischenschicht 2 und eine auf letzterer wiederum epitaktisch aufgewachsene Schmalbandhalbleiterschicht 3 auf. Mehrere auf Infrarotstrahlung empfindliche Sensoren 4 sind in die Schmalbandhalbleiterschicht 3 integriert. Im Halbleitersubstrat 1 sind Teile 5 einer elektronischen Schaltungsanordnung zur Auswertung, insbesondere Verstärkung und Multiplexierung, der von den Sensoren 4 gelieferten elektrischen Spannungen integriert, wobei die Schaltungsanordnung auch sogenannte Charge Coupled Devices aufweisen kann.

Das Halbleitersubstrat 1 besteht z.B. aus (111)-Si, dessen Gitterkonstante (bei üblicher Raumtemperatur) 0,543 nm beträgt (Fig. 2). Die Schmalbandhalbleiterschicht 3 besteht z.B. aus PbSe mit einer Gitterkonstante von 0,612 nm. Die Zwischenschicht 2 ist aus mehreren Teilzwischenschichten mit etwas verschiedenen Gitterkonstanten zusammengesetzt. Unmittelbar auf das Halbleitersubstrat 1 ist eine erste Teilzwischenschicht aus reinem $CaF_2$ epitaktisch aufgebaut, dessen Gitterkonstante bei Raumtemperatur 0,546 nm beträgt und somit nur um 0,6% grösser als diejenige von Si ist. Die letzte, d.h. an die Schmalbandhalbleiterschicht 3 angrenzende Teilzwischenschicht, besteht aus reinem $BaF_2$ mit einer Gitterkonstante von 0,620 nm, die um 1,2% grösser als diejenige von PbSe ist. Dazwischenliegende weitere Teilzwischenschichten sind in ihrer Zusammensetzung graduell oder stufenweise veränderte Mischkristalle der Formel $Ca_{1-x}Ba_xF_2$, in welcher x zwischen 0 und 1 liegt und gegen die letzte Teilzwischenschicht hin zunehmend grösser wird. Die Gitterkonstanten dieser Mischkristalle liegen zwischen jenen von $CaF_2$ und $BaF_2$ und nehmen mit wachsendem x ebenfalls zu. Somit variiert die Gitter konstante der Zwischenschicht 2 über deren Dicke von einem Wert in der Nähe der Gitterkonstanten des

Halbleitersubstrats Si bis zu einem Wert in der Nähe der Gitterkonstanten der Schmalbandhalbleiterschicht PbSe.

Die beschriebene Zwischenschicht 2 kann durch Molekularstrahl-Epitaxie oder auch konventionelles Vakuumverdampfen epitaktisch aufgebaut werden, wie z.B. für $CaF_2$-, $SrF_2$- oder $BaF_2$-Wachstum von T. Asano et al. in Jap. J. Appl. Phys. 22, 1474 (1983), beschrieben wurde.

Zur Herstellung der Zwischenschicht können zwei separate Tiegel, von denen einer $BaF_2$ und einer $CaF_2$ enthält, verwendet und die Wachstumsraten z.B. mit zwei Schwingquarzen kontrolliert werden. Der nötige Druck im Rezipienten soll unterhalb $7 \cdot 10^{-5}$ Pa ($5 \cdot 10^{-7}$ Torr) liegen; es ist jedoch nicht unbedingt nötig, unter UHV (UltraHochVakuum)-Bedingungen zu arbeiten. Der polierte Si-Wafer wird während des Aufdampfens auf einer Temperatur von 200-800°C gehalten und vorzugsweise auf eine noch höhere Temperatur vor Beginn der Aufdampfung zur Reinigung seiner Oberfläche gebracht. Die Aufdampfrate liegt zu Beginn der Aufdampfung, bis sich eine erste zusammenhängende Lage gebildet hat, vorzugsweise unterhalb 0,01 nm/sec und kann danach, falls die Temperatur genügend hoch und die Schichtoberfläche genügend sauber ist, bei genügend guten Druckverhältnissen im Rezipienten bis auf etwa 1 nm/sec gesteigert werden. Bei dem hier betrachteten Beispiel wird zuerst reines $CaF_2$ verdampft. Danach wird durch geeignete allmähliche Erhöhung der Temperatur der $BaF_2$ Quelle und Verminderung der Temperatur der $CaF_2$ Quelle ein sich in der Zusammensetzung graduell ändernder Mischkristall von $Ca_{1-x}Ba_xF_2$ mit zunehmendem x gebildet, bis zuletzt reines $BaF_2$ aufgedampft wird. Die Dicke der gesamten Zwischenschicht 2 kann ca. 10 nm bis einige µm betragen. Gemäss bekanntem Phasendiagramm ist zwar ein (Ba, Ca)$F_2$ Mischkristall thermodynamisch nicht stabil, es ist jedoch bekannt, dass durch Aufdampfen aus der Gasphase sich ein metastabiler Mischkristall bildet.

Alternativ kann über die auch im Gleichgewicht sich bildenden Mischkristallreihen

$$CaF_2 \rightarrow (Ca, Sr)F_2 \rightarrow SrF_2 \rightarrow (Sr, Ba)F_2 \rightarrow BaF_2$$

die gewünschte Zusammensetzung der Zwischenschicht 2 erhalten werden. Ebenfalls kann durch Einbezug von $Cd_{1-y}Ca_yF_2$ mit $y \approx 0.6$ zu Beginn der Aufdampfung die Gitterpassung zwischen dem Si-Substrat 1 und der Zwischenschicht 2 verbessert werden. Das gleiche gilt auch für die Grenzfläche PbSe/Zwischensicht, bei der mit $Ca_{1-x}Ba_xF_2$ mit $x \approx 0.9$ die Gitterpassung weiter verbessert werden kann. Die PbSe-Schicht 3 wird anschliessend in einem separaten System z.B. durch Heisswandepitaxie bis zu einer Schichtdicke im Bereich von z.B. 0,5 - 5 µm aufgewachsen, wie z.B. von H. Holloway in Physics of thin films 11, 105 (1980) beschrieben wurde.

Die Infrarot-Sensoren 4 können z.B. aus PbTe oder $PbS_{1-x}Se_x$ mit $0 \leqslant x \leqslant 1$ bestehen, in welchem Fall die Sensoren im Infrarotfenster für Wellenlängen von 3-5 µm empfindlich sind. Bestehen hingegen die Sensoren 4 aus $Pb_{1-x}Sn_xTe$ mit $x \approx 0,2$ oder aus $Pb_{1-x}Sn_xSe$ mit $x \approx 0,07$, so resultiert eine Infrarot-Empfindlichkeit im Fenster für Wellenlängen von 8-14 µm.

Die übrigen Verfahrensschritte für die Herstellung des opto-elektronischen Bauteils sind ähnlich wie bei der bekannten Erzeugung von integrierten elektronischen Chips. Die gewünschte laterale Struktur der Fluoridschicht 2 und/oder der PbSe-Schicht 3, z.B. verschieden grosse Flächenbereiche wie in Fig. 1 angedeutet, kann mit Hilfe von Schattenmasken während der Schichtherstellung oder nachträglich mittels der Photolithographietechnik erhalten werden. Mit danach aufgedampften Pb-Flächen können z.B. Schottkykontakte und mit aufgesputtertem Pt die nötigen ohmschen Anschlusskontakte hergestellt werden (in Fig. 1 nicht gezeigt). Alternativ können photovoltaische Infrarotsensoren 4 mittels Diffusion oder Ionenimplantation hergestellt werden. Nicht dargestellte elektrische Verbindungen zum Si-Wafer 1 sind mittels trisch isolierende Zwischenschicht 2 geätzt werden, nötigenfalls weitere Isolationsschichten auf der PbSe-Schicht 3 für die elektrische Isolation aufgebracht werden und mit einem aufgedampften Metall und zugehöriger Ätzung die nötige elektrische Verbindungsstruktur definiert wird.

Das beschriebene Ausführungsbeispiel kann in mancher Hinsicht modifiziert werden. So ist es z.B. möglich, das Halbleitersubstrat 1 anstatt aus Si aus einem Material der Gruppe Ge, $Ga_{1-x}Al_xAs$, InP, InSb, GaSb und CdTe herzustellen mit oder ohne epitaktisch aufgewachsener Schicht aus gleichem oder ähnliche Halbleitermaterial.

Ferner sind für die Schmalbandhalbleiterschicht 3 ausser PbSe andere Materialien, wie PbTe, PbS, $Pb_{1-x}Sn_xTe$, $Pb_{1-x}Sn_xSe$, $PbS_{1-x}Se_x$ oder $Pb_{1-x}Cd_xS$ mit jeweils $0 \leqslant x \leqslant 1$ oder allgemeiner und kompakt geschrieben

$$(Pb_{1-w-x}Sn_xCd_w)(S_{1-y-z}Se_yTe_z) \text{ mit } 0 \leqslant w \leqslant 1, 0 \leqslant x \leqslant 1, 0 \leqslant y \leqslant 1, 0 \leqslant z \leqslant 1$$

verwendbar, wobei einer oder mehrere der Parameter w, x, y, z über die Schichtdicke variieren können.

Ebenfalls können andere Schmalbandhalbleiter, wie $Hg_{1-x}Cd_xTe$ oder $InAs_xSb_{1-x}$ ($0 \leqslant x \leqslant 1$), nötigenfalls mit über ihre Schichtdicke sich ändernder Zusammensetzung x verwendet werden.

Die Zwischenschicht 2 kann allgemein aus Fluoriden von Metallen der Gruppe IIa ($MF_2$, wobei M = Metall) gewachsen werden, insbesondere als Mischkristall

$$Ca_xSr_yBa_zCd_{1-x-y-z}F_2 \text{ mit } 0 \leqslant x \leqslant 1, 0 \leqslant y \leqslant 1, 0 \leqslant z \leqslant 1,$$

wobei die Gitterkonstante des Mischkristalls abhängig von den Werten von x, y und z ist. Die ebenfalls als Spezialfall mit der obigen chemischen Formel beschriebenen Randzusammensetzungen weisen folgende Gitterkonstanten d bei Raumtemperatur auf (vgl. Fig. 2):

| | |
|---|---|
| $CdF_2$ | d = 0.539 nm |
| $CaF_2$ | d = 0.546 nm |
| $SrF_2$ | d = 0.580 nm |
| $BaF_2$ | d = 0.620 nm. |

Mit dem Fluorid-Mischkristall können somit Gitterkonstanten «massgeschneidert» werden im Bereich von 0.539 bis 0.620 nm, da diese stetig und monoton mit der Zusammensetzung variieren. Dabei können die Metallatome in der Formel $MF_2$ aus nur einem, zwei oder auch drei verschiedenen oder allen der vier obigen Elemente bestehen. Wie bei dem mit Bezug auf Fig. 1 beschriebenen Beispiel kann die Zusammensetzung der Zwischenschicht im Laufe ihres Wachstums graduell oder auch stufenweise verändert werden, so dass Teilzwischenschichten mit verschiedenen Gitterkonstanten resultieren, derart dass an den Grenzflächen zum halbleitersubstrat 1 und zur Schmalbandhalbleiterschicht 3 eine gute Gitteranpassung, d.h. wenig Gitterfehler, erhalten wird, was zur Erzielung einer guten Qualität der epitaktisch aufgewachsenen Schmalbandhalbleiterschicht 3 von Vorteil ist.

Eine genaue Gitteranpassung an den Grenzflächen zur Zwischenschicht 2 ist nicht in jedem Fall Voraussetzung für die epitaktische Herstellung einer Schmalbandhalbleiterschicht 3 mit den gewünschten elektronischen Materialeigenschaften. Zum Beispiel lässt sich auch eine gute PbSe-Schicht mit starkem Anstieg der Hall-Beweglichkeiten (bis zu $10^5$ $cm^2/Vsec$ bei Temperaturen unterhalb 30K) beim Abkühlen erzielen, wenn als Zwischenschicht 2 nur $BaF_2$ oder stufenweise zuerst $CaF_2$ und dann $BaF_2$ aufgewachsen wird.

In manchen Fällen kann es aus chemischen Gründen oder zur Verbesserung der Haftfähigkeit zweckmässig und vorteilhaft sein, zwischen dem Halbleitersubstrat 1 (Fig. 1) und der Schmalbandhalbleiterschicht 3 mindestens eine nur wenige Monolagen dicke zusätzliche Zwischenschicht anzubringen, die keine Epitaxieschicht zu sein braucht, aber das epitaktische Anwachsen der darüberliegenden Schicht 2 oder 3 nicht beeinträchtigt. Eine derartige zusätzliche Zwischenschicht kann z.B. eine dünne Oxidschicht auf dem Substrat 1 oder zwischen der Zwischenschicht 2 und der Schmalbandhalbleiterschicht 3 sein. Es ist aber auch möglich, eine zusätzliche dünne Zwischenschicht der genannten Art zwischen zwei epitaktisch hergestellten Fluorid-Zwischenschichten anzuordnen.

Durch die beschriebene Erfindung ist ermöglicht, mit Hilfe der Zwischenschicht 2 die Schmalbandhalbleiterschicht 3 epitaktisch auf dem Halbleitersubstrat 1 aufzubauen, obwohl die Gitterkonstanten der für das Halbleitersubstrat und die Schmalbandhalbleiterschicht verwendeten Materialien einen beträchtlichen Unterschied in der Grössenordnung von bis zu 16% — je nach den Materialien — aufweisen. Ohne die Zwischenschicht wäre es aus physikalischen Gründen nicht möglich, Materialien mit derart grossen Unterschieden ihrer Gitterkonstanten epitaktisch miteinander zu verbinden. Die Verwendung einer Zwischenschicht mit kubischer Kalciumfluorid-Struktur, insbesondere $MF_2$, erlaubt zudem auch die Erzielung vorzuglicher opto-elektronischer Eigenschaften des monolithischen Bauteils. Diesbezüglich wird auf die folgenden Publikationen verwiesen: H. Zogg, W. Vogt und H Melchior in Infrared Phys. 25, 333 (1985) und H. Zogg und M Hüppi in Appl. Phys. Lett. 47 (1985).

Der erfindungsgemässe opto-elektronische Bauteil ist insbesondere für die Verwendung als sogenannter Focal Plane Array in einer elektronischen Wärmebildkamera geeignet, wobei im Betrieb in bekannter Weise eine Kühlung des Bauteils bis hinab auf 77K (−196°C) erforderlich ist, je nach den Anforderungen und dem Wellenlängenbereich.

Der erfindungsgemässe Bauteil kann auch als Infrarotstrahlung führender opto-elektronischer Wandler ausgebildet sein, mit dessen Hilfe es möglich ist, eine Infrarotstrahlung zu modulieren.

**Patentansprüche**

1. Opto-elektronischer Bauteil mit mindestens einem auf Infrarotstrahlung empfindlichen, Infrarotstrahlung führenden oder Infrarotstrahlung emittierenden opto-elektronischen Wandler, bei welchem Bauteil auf einem Halbleitersubstrat mit Hilfe mindestens einer auf dem Substrat epitaktisch aufgewachsenen Zwischenschicht eine weitere Halbleiterschicht aus einem Schmalbandhalbleiter epitaktisch aufgewachsen ist und in dieser Schmalbandhalbleiterschicht der opto-elektronische Wandler integriert ist und die Zwischenschicht an ihren Grenzflächen zum Halbleitersubstrat und zu der Schmalbandhalbleiterschicht jeweils Gitterkonstanten aufweist, die zwischen oder in der Nähe jener des Halbleitersubstrates bzw. jener der Schmalbandhalbleiterschicht liegen, wobei die Zwischenschicht eine kubische Kalziumfluoridstruktur, insbesondere $MF_2$, aufweist und aus mindestens zwei Teilzwischenschichten mit unterschiedlicher Zusammensetzung aufgebaut ist, deren Gitterkonstanten eine Reihe bilden von einem Wert in der Nähe der Gitterkonstante des Halbleitersubstrates zu einem Wert in der Nähe der Gitterkonstante der Schmalbandhalbleiterschicht.

2. Opto-elektronischer Bauteil nach Anspruch 1, dadurch gekennzeichnet, dass das Halbleitersubstrat aus einem Material der Gruppe Si, Ge, $Ga_xAl_{1-x}As$ mit $0 \leqslant x \leqslant 1$, InP, GaSb, InSb und CdTe besteht, die Zwischenschicht aus einem Material mit kubischer Kalziumfluorid-Struktur besteht und die Schmalbandhalbleiterschicht aus einem Mischkristall der Gruppe $Pb_{1-w-x}Cd_wSn_xS_{1-y-z}Se_yTe_z$ mit $0 \leqslant w \leqslant 1$, $0 \leqslant x \leqslant 1$, $0 \leqslant y \leqslant 1$ und $0 \leqslant z \leqslant 1$, $Hg_{1-x}Cd_xTe$ mit $0 \leqslant x \leqslant 1$ und $InAs_{1-x}Sb_x$ mit $0 \leqslant x \leqslant 1$ besteht, wobei die Parameter w, x, y und z über die Dicke der Schmalbandhalbleiterschicht variieren können.

3. Opto-elektronischer Bauteil nach einem der Ansprüche 1 bis 2, dadurch gekennzeichnet, dass die Zwischenschicht aus $Ca_xSr_yBa_zCd_{1-x-y-z}F_2$ mit $0 \leqslant x \leqslant 1$, $0 \leqslant y \leqslant 1$ und $0 \leqslant z \leqslant 1$ besteht.

4. Opto-elektronischer Bauteil nach einem der Ansprüche 1 bis 3, dadurch gekennzeichnet, dass die Schmalbandhalbleiterschicht aus einem Mischkristall der Gruppe $Pb_{1-x}Sn_xTe$, $Pb_{1-x}Sn_xSe$, $Pb_{1-x}Cd_xS$ und $PbS_{1-x}Se_x$ mit jeweils $0 \leqslant x \leqslant 1$ besteht und die darin integrierten opto-elektronischen Wandler über mindestens einem Wellenlängenbereich innerhalb des Bereiches von 1,5 bis 15 µm arbeiten, und dass im Halbleitersubstrat zumindest ein Teil einer elektronischen Schaltungsanordnung für

die Verarbeitung der elektrischen Signale der opto-elektronischen Wandler integriert ist.

5. Opto-elektronischer Bauteil nach Anspruch 4, dadurch gekennzeichnet, dass der opto-elektronische Wandler aus einem Material der Gruppe PbTe und $PbS_{1-x}Se_x$ mit $0 \leqslant x \leqslant 1$ besteht und ein im 3-5 µm-Infrarotfenster empfindlicher Sensor ist.

6. Opto-elektronischer Bauteil nach Anspruch 4, dadurch gekennzeichnet, dass der opto-elektronische Wandler aus einem Material der Gruppe $Pb_{1-x}Sn_xTe$ und $Pb_{1-x}Sn_xSe$ besteht, wobei x derart gewählt ist, dass der opto-elektronische Wandler ein im 8-14 µm-Infrarotfenster empfindlicher Sensor ist.

7. Opto-elektronischer Bauteil nach einem der Ansprüche 1 bis 6, dadurch gekennzeichnet, dass zwischen dem Halbleitersubstrat und der Schmalbandhalbleiterschicht mindestens eine nur wenige Monolagen dicke zusätzliche Zwischenschicht, z.B. aus einem Oxid, vorhanden ist, die keine Epitaxieschicht zu sein braucht.

## Claims

1. Optoelectronic component with at least one optoelectronic transducer sensitive to infrared radiation and conducting or emitting infrared radiation, said component having on a semiconductor substrate at least one intermediate layer formed thereon by epitaxial growth and a further semiconductor layer formed by the aid of said intermediate layer by epitaxial growth from a narrow-gap semiconductor, said optoelectronic transducer being integrated into said narrow-gap semiconductor layer and said intermediate layer presenting at its interfaces to the semiconductor substrate and the narrow-gap semiconductor layer respectively a lattice constant between or near the one of the semiconductor substrate or the one of the narrow-band semiconductor layer respectively, whereby said intermediate layer has a structure of cubic calcium fluoride, particularly $MF_2$, and is constituted of at least two partial intermediate layers of different composition having lattice constants forming a series having a value near the one of the lattice constant of the semi-conductor substrate to the value near the one of the lattice constant of said narrow-gap semiconductor layer.

2. Optoelectronic component according to claim 1, characterized in that said semiconductor substrate is composed of a material of the group Si, Ge, $Ga_xAl_{1-x}As$ with $0 \leqslant x \leqslant 1$, InP, GaSb, InSb and CdTe, the intermediate layer of a material with a structure of cubic calcium fluoride and the narrow-gap semiconductor layer of a solid solution of the group $Pb_{1-w-x}Cd_wSn_xS_{1-y-z}Se_yTe_z$ with $0 \leqslant w \leqslant 1$, $0 \leqslant x \leqslant 1$, $0 \leqslant y \leqslant 1$ and $0 \leqslant z \leqslant 1$, $Hg_{1-x}Cd_xTe$ with $0 \leqslant x \leqslant 1$ and $InAs_{1-x}Sb_x$ with $0 \leqslant x \leqslant 1$, whereby the parameters w, x, y and z may vary across the thickness of the narrow-gap semi-conductor layer.

3. Optoelectronic component according to any of claims 1 to 2, characterized in that the intermediate layer is composed of $Ca_xSr_yBa_zCd_{1-x-y-z}F_2$ with $0 \leqslant x \leqslant 1$, $0 \leqslant y \leqslant 1$ and $0 \leqslant z \leqslant 1$.

4. Optoelectronic component according to any of claims 1 to 3, characterized in that the narrow-gap semi-conductor layer is composed of a solid solution of the group $Pb_{1-x}Sn_xTe$, $Pb_{1-x}Sn_xSe$, $Pb_{1-x}Cd_xS$ and $PbS_{1-x}Se_x$ with $0 \leqslant x \leqslant 1$ and in that said optoelectronic transducers integrated therein are working over at least a wave length range within the range 1,5 to 15 µm, and in that at least a part of the electronic circuit for treating the electrical signals of said optoelectronic transducers is integrated in said semiconductor substrate.

5. Optoelectronic component according to claim 4, characterized in that said optoelectronic transducer is composed of a material of the group PbTe and $PbS_{1-x}Se_x$ with $0 \leqslant x \leqslant 1$, and constitutes a sensor sensitive in the 3-5 µm infrared window.

6. Optoelectronic component according to claim 4, characterized in that said optoelectronic transducer is composed of a material of the group $Pb_{1-x}Sn_xTe$ and $Pb_{1-x}Sn_xSe$, x being chosen such that the optoelectronic transducer constitutes a sensor sensitive in the 8-14 µm infrared window.

7. Optoelectronic component according to any of claims 1 to 6, characterized in that there is provided between said semiconductor substrate and said narrow-gap semiconductor layer at least one additional intermediate layer of a thickness of only a few monolayers, e.g. composed of an oxide, which does not need to be an epitaxial layer.

## Revendications

1. Elément optoélectronique avec au moins un transducteur optoélectronique sensible aux rayons infrarouge et parcouru par ou émettant des rayons infrarouge, ledit élément présentant sur un substrat semi-conducteur au moins une couche intermédiaire formée par épitaxie et une autre couche de semi-conducteur formée à l'aide de la couche intermédiaire par épitaxie à partir d'un semi-conducteur à bande étroite, ledit transducteur optoélectronique étant intégré dans la couche de semi-conducteur à bande étroite et la couche intermédiaire présentant sur ses couches de jonction du côté couche intermédiaire et du côté couche de semi-conducteur à bande étroite respectivement des constantes de réseau se situant entre ou voisin de celle du substrat semi-conducteur et de celle de la couche de semi-conducteur à bande étroite respectivement, ladite couche intermédiaire présentant une structure du fluorure de calcium cubique, notamment $MF_2$, et composée d'au moins deux couches intermédiaires partielles à composition distincte, dont les constantes de réseau forment une suite d'une valeur proche de la constante de réseau du substrat semi-conducteur jusqu'à une valeur proche de la constante de réseau de la couche de semi-conducteur à bande étroite.

2. Elément optoélectronique selon la revendication 1, caractérisé en ce que le substrat semi-conducteur est composé d'une matière comprenant le groupe Si, Ge, $Ga_xAl_{1-x}As$ avec $0 \leqslant x \leqslant 1$, InP, GaSb, InSb et CdTe, la couche intermédiaire est en une matière avec la structure du fluoride de calcium cubique et la couche de semi-conducteur à bande étroite est composée d'une solution solide du groupe

$Pb_{1-w-x}Cd_wSn_xS_{1-y-z}Se_yTe_z$ avec $0 \leqslant w \leqslant 1$, $0 \leqslant x \leqslant 1$, $0 \leqslant y \leqslant 1$ et $0 \leqslant z \leqslant 1$, $Hg_{1-x}Cd_xTe$ avec $0 \leqslant x \leqslant 1$ et $InAs_{1-x}Sb_x$ avec $0 \leqslant x \leqslant 1$, les paramètres w, x, y et z pouvant varier à travers l'épaisseur de la couche de semi-conducteur à bande étroite.

3. Elément optoélectronique selon l'une des revendications 1 à 2, caractérisé en ce que la couche intermédiaire est en $Ca_xSr_yBa_zCd_{1-x-y-z}F_2$ avec $0 \leqslant x \leqslant 1$, $0 \leqslant y \leqslant 1$ et $0 \leqslant z \leqslant 1$.

4. Elément optoélectronique selon l'une des revendications 1 à 3, caractérisé en ce que la couche de semiconducteur à bande étroite est composée d'une solution solide du groupe $Pb_{1-x}Sn_xTe$, $Pb_{1-x}Sn_xSe$, $Pb_{1-x}Cd_xS$ et $Pb_{1-x}Se_{1-x}$ avec chaque fois $0 \leqslant x \leqslant 1$ et en ce que les transducteurs optoélectroniques qui y sont intégrés travaillent dans au moins une gamme de longueur d'ondes à l'intérieur de la gamme de 1,5 à 15 µm et en ce qu'au moins une partie d'un circuit électronique pour le traitement des signaux provenant du transducteur optoélectronique est intégrée dans ledit substrat semi-conducteur.

5. Elément optoélectronique selon la revendication 4, caractérisé en ce que le transducteur optoélectronique est composé d'une matière du groupe PbTe et $PbS_{1-x}Se_x$ avec $0 \leqslant x \leqslant 1$ et constitue un détecteur sensible dans la fenêtre infrarouge 3-5 µm.

6. Elément optoélectronique selon la revendication 4, caractérisé en ce que le transducteur optoélectronique est composé d'une matière du groupe $Pb_{1-x}Sn_xTe$ et $Pb_{1-x}Sn_xSe$, la valeur de x étant choisie telle, que le transducteur optoélectronique constitue un détecteur sensible dans la fenêtre infrarouge 8-14 µm.

7. Elément optoélectronique selon l'une des revendications 1 à 6, caractérisé en ce qu'il présente, entre le substrat semi-conducteur et la couche de semi-conducteur à bande étroite, au moins une couche intermédiaire supplémentaire d'une épaisseur de quelques monocouches seulement, formée par exemple d'un oxyde et qui ne doit pas être une couche épitaxiale.

FIG. 1

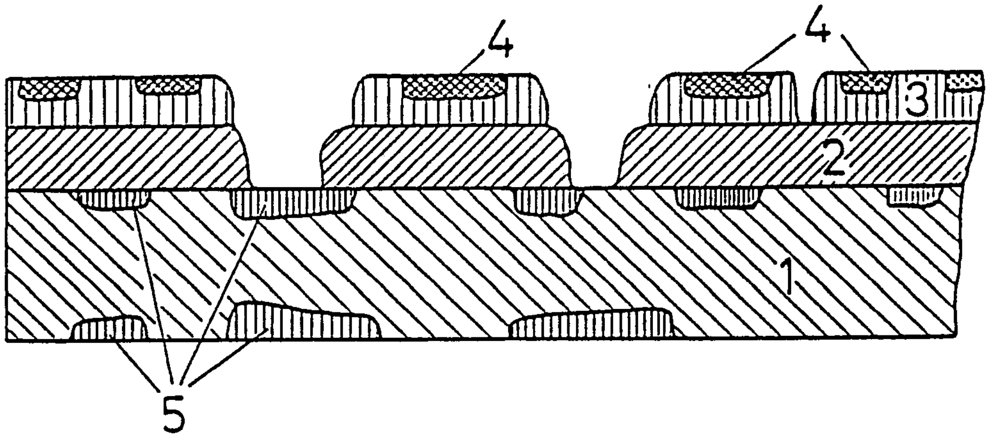
4
4
3
2
1
5

FIG. 2

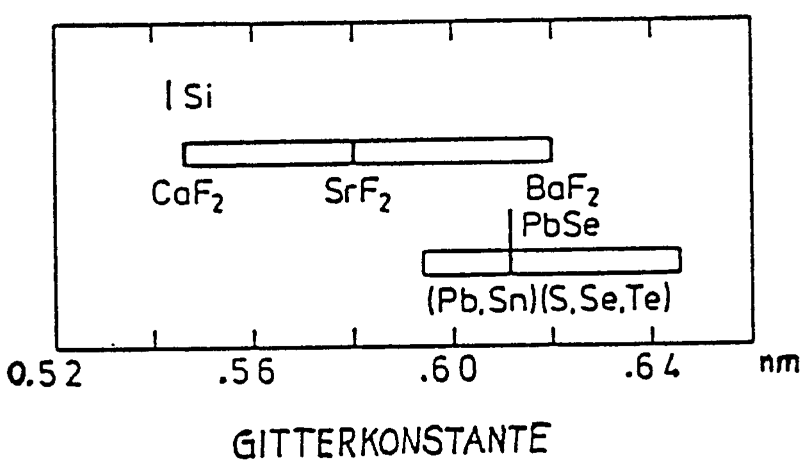
Si
CaF2
SrF2
BaF2
PbSe
(Pb,Sn)(S,Se,Te)
0.52
.56
.60
.64
nm
GITTERKONSTANTE